# EUROPEAN PATENT APPLICATION

(11) **EP 1 328 013 A1**
(43) Date of publication of application: **16.07.2003**
(21) Application number: 02000697.9
(22) Date of filing: 11.01.2002
(51) Int. Cl.: H01L 21/033, H01L 21/3213

(54) **Method of forming a line structure in a layer of a semiconductor wafer**

(71) Applicant: Infineon Technologies AG, 81669 München (DE)
(72) Inventor: Schmidt, Sebastian, 01127 Dresden (DE); Spuler, Bruno, 81373 München (DE); Schedel, Thorsten, 01129 Dresden (DE)
(74) Representative: Epping Hermann & Fischer

(57) **Abstract**

A first layer (20), a hardmask layer (30), and a resist layer (40) are deposited on a semiconductor wafer (10), and the resist layer (40) is patterned in a lithographic projection step. A first etch step (110) is performed on the hardmask layer (30) to expose a portion (92) of the first layer (20), leaving a line (5) formed by the patterned resist layer (40) and the patterned hardmask layer (30) beneath. The hardmask layer (30), which is comparatively thin, is then isotropically etched in a horizontal direction reducing its size to a reduced line width (8). The resist layer (40) is removed and in a third anisotropically performed etch step (130), the line (5) is transferred into the first layer (20) having a line width (8) which is smaller than the initial line width (7) formed by lithographic projection. In particular, sub resolution line width (8) may be formed. Using an anorganic material for the hardmask layer (30), high etch selectivities are provided for the hardmask layer (30) material with respect to the resist layer (40) and the first layer (20). Resist layer (40) is marginally affected, enabling an accurate line width control of the hardmask layer patterned line width (8).

## Description

The present invention relates to a method of forming a line structure in a layer of a semiconductor wafer. In particular, the invention relates to a method for structuring line widths at about the resolution limit of the lithographic projection system, which exposes the wafer.

With continuously decreasing design rules employed for structuring wafers in semiconductor industry, the efforts spent in producing logic or memory products is getting increasingly challenging. The advance to the next smaller design rule, e.g. currently from 0,13 µm to 0,11 µm, is generally limited by stringent tolerances of critical dimension, overlay control, or wafer-to-wafer uniformity etc. of minimum structure sizes, while maintaining a sufficiently high yield. So-called lithographic enhancement techniques are more and more employed to improve the projection characteristics of the current lithography generation, e.g. optical proximity correction (OPC), phase shifting masks (PSM, alternating, chrome-less, or half-tone), or off-axis illumination are applied. These techniques may push the limit to even smaller minimum structure sizes, but likewise bring about a considerable increase in production costs of semiconductor devices. Additionally, the shrink from 0,13 µm to 0,11 µm design rules involves a step using DUV (Deep-UV) lithographic projection systems from KrF-illumination towards ArF-illumination, which also adds to the costs for producing a wafer.

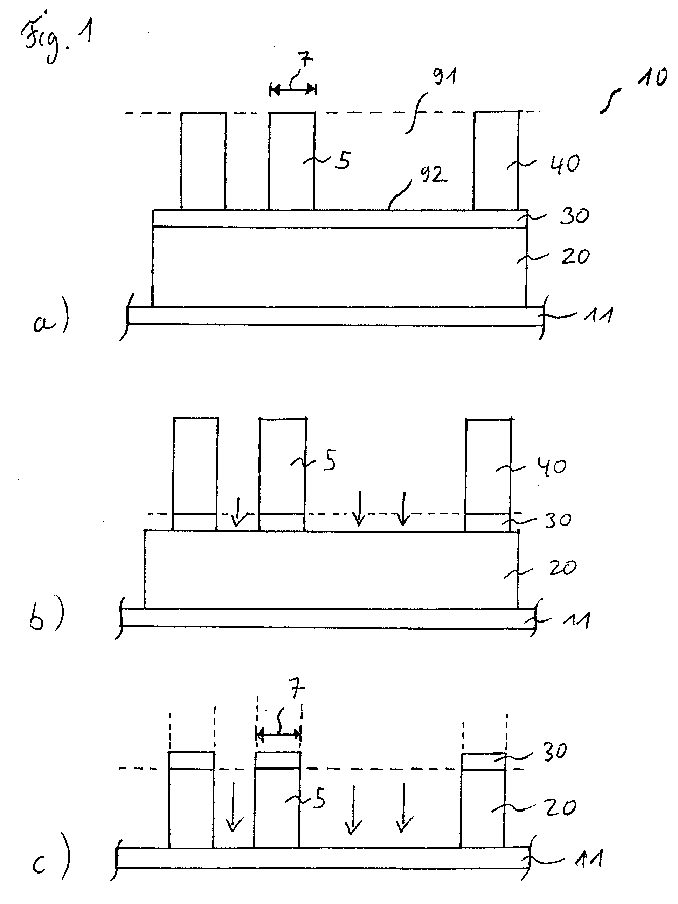

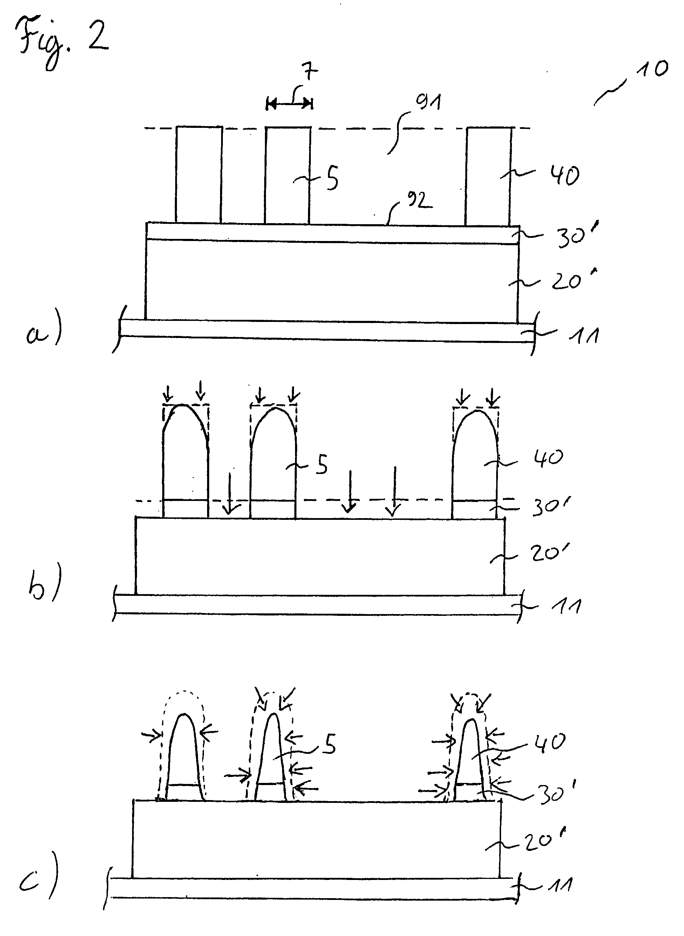

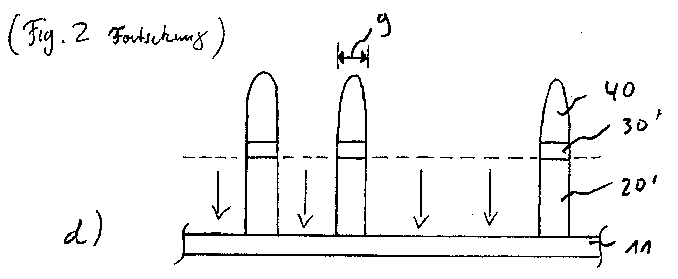

Therefore, it has been an objective to provide alternative techniques to enable the manufacturing of even smaller structure sizes without utilizing cost-sensitive alterations of the optical projection system, or stepping towards next-generation lithography techniques like EUV (extreme ultra violet) or X-ray techniques. In US 6,010,829 a method is provided where etching techniques are used to push the line width of a line being structured in a lithographic projection step below the lithographic resolution limit. The procedure is described in figure 2 and compared with another conventional line forming method, which is not able to produce subresolution structure sizes, shown in figure 1:

In figure 1a, a surface profile of a semiconductor wafer 10 is shown, comprising a substrate layer 11, a first layer 20, an ARC-layer 30 (Anti-Reflex Coating), and a resist layer 40. Using a lithographic projection tool, a line 5 of a pattern having a line width 7 is formed, and in a development step, portions 91 of the resist layer are removed such that a surface portion 92 of the ARC-layer 30 is exposed to the wafer surface. In the conventional method accordingly shown in figure 1b, the ARC-layer 30 is etched anisotropically to transfer the resist pattern into the ARC-layer 30. This is followed by preferably performing an anisotropic etch step to transfer this pattern further into the first layer 20, forming line 5 of the desired material. Rest portions of the resist layer 40 forming top portions of line 5 are then removed. The lithographically structured line width 7 in the resist line 5 more or less retains its dimension when line 5 is being transferred into the first layer 20. In particular, it has a value above the resolution limit of the lithographic projection system.

A process corresponding to the method disclosed in US 6,010,829 is displayed in figure 2. Figure 2a shows for comparison the same starting point after lithographic structuring as in figure 1a. The method aims at structuring subresolution poly-silicon gate lengths in a poly-silicon layer 20'. An organic ARC-layer 30' is deposited upon the first layer 20', forming a bottom layer with respect to an organic resist layer 40. An anisotropic etch process is performed on this organic ARC-layer 30' to transfer the resist pattern into the ARC-layer 30'. As a consequence of the etch process, the resist line profile of the organic resist is also affected by, e.g. roundening the resist profile edges as can be seen in figure 2b. This is followed by an isotropic etch process with a selectivity of about one-to-one of both organic materials. Theoretically, it can be expected that the line width 7 of line 5 in this process shrinks at the same rate in the top resist and bottom ARC-layer of the organic material stack of line 5. Under realistic conditions, however, the isotropic etch process will affect the edges stronger than the bottom parts of this stack. Therefore, it might occur that a tapered profile evolves (figure 1c). Line 5, having a reduced line width 9, is then transferred in an anisotropic etch process into the poly-silicon layer 20'. A value below the lithographic projection resolution limit can be achieved.

Such a technique has the disadvantage that a rectangular profile of the organic material stack composed of the bottom ARC-layer 30' and the resist layer 40 is hard to be maintained. This leads to the problem that in the following anisotropic etch process it is not clear, which actual line width 9 is transferred into the poly-silicon layer 20'. Moreover, several etch processes applied to the organic resist material stack might lead to an increased contamination of the substrate.

It is therefore an objective of the present invention to provide a method for forming lines, having line widths at or below the resolution limit of the lithographic projection system, which at the same time provides an accurate control of the line width produced.

The objective is solved by a method of forming a line in a first layer of a semiconductor wafer, comprising the steps of depositing said first layer on said wafer, depositing a hardmask layer comprising anorganic material upon said first layer, depositing a resist layer upon said hardmask layer, exposing said resist layer with a pattern comprising said line having a first line width, removing a pattern portion from said resist layer, such that an underlying portion of said hardmask layer is exposed to the wafer surface, first etching being performed on said portion of said hardmask layer using said patterned resist layer as a first etch mask to form a hardmask pattern comprising said line within said hardmask layer, second etching being performed isotropically on said hardmask layer beneath said pattern resist layer for reducing said first line width of said line to a second line width within said hardmask layer, removing said resist layer, third etching being performed unisotropically on said hardmask layer for transferring said hardmask pattern into said first layer.

According to the present invention, a hardmask layer deposited upon the first layer to be structured with the line is used to effect a reduced line width of said line. After the lithographic projection step and development, the hardmask layer is patterned, leading to a stack of the hardmask layer and the resist pattern on its top. This stack has the overall line width originating from the lithographic projection step. The first etch step, leading to this configuration, may be performed anisotropically or isotropically. Since the hardmask layer is comparatively thin, the etching has to be performed until an etch stop on top of the first layer to be structured in order to be able to affect the pattern hardmask layer at the bottom of said stack.

According to the present invention, the hardmask layer comprises anorganic material. Therefore, an etch process with high selectivity to the hardmask material with respect to the organic resist material is possible. Moreover, since the resist material on top of the stack is marginally affected by the isotropic etch process working in a horizontal direction, an accurate, substantially rectangular hardmask layer profile having reduced line width evolves during the isotropic etch step. Advantageously, the current line width during the isotropic etch process is well-known as a function of time if the typical etch rate of the process is known.

The material used in the hardmask layer and the first layer require a condition of high etch selectivity in etch processes according to the present invention. For example, an oxide and/or nitride compound may be used for the hardmask layer, and metals or metal compounds like TiN on top of aluminum or tungsten or poly-silicon or any other suitable material providing high selectivity for a suitable etch process with respect to oxide or nitride can be used for the first layer. As generally an etch process with opposite selectivity exists, the material compositions stated above for the hardmask and first layer can also directly be exchanged. Thus, conductive metal or poly-silicon lines are suitable for hardmask layer as well as oxide / nitride material for the first layer according to the present invention.

Since the patterned resist layer on top of the shrinked hardmask pattern is not affected by the isotropic etch process, no deterioration of the rectangular stack profile occurs. Since the resist is not further needed for structuring in the etch process, it can be removed prior to being affected by further etch bombardment. Advantageously, the hardmask pattern line width can be accurately controlled by timed etching, which is superior to prior art because the resist pattern has the function of protecting the hardmask pattern during the etch process, rather than providing the pattern for the third etch process.

Further advantages and aspects are evident from the dependent claims.

The invention will be better understood by an explanation of embodiments taken in conjunction with accompanying figures, wherein:
- Figure 1: schematically shows a method forming a line in a first layer according to prior art without reducing the line width,
- Figure 2: shows a process sequence of forming a line in a first layer according to prior art with reducing the line width,
- Figure 3: shows a process sequence of forming a line according to an embodiment of the present invention accurately reducing the line width.

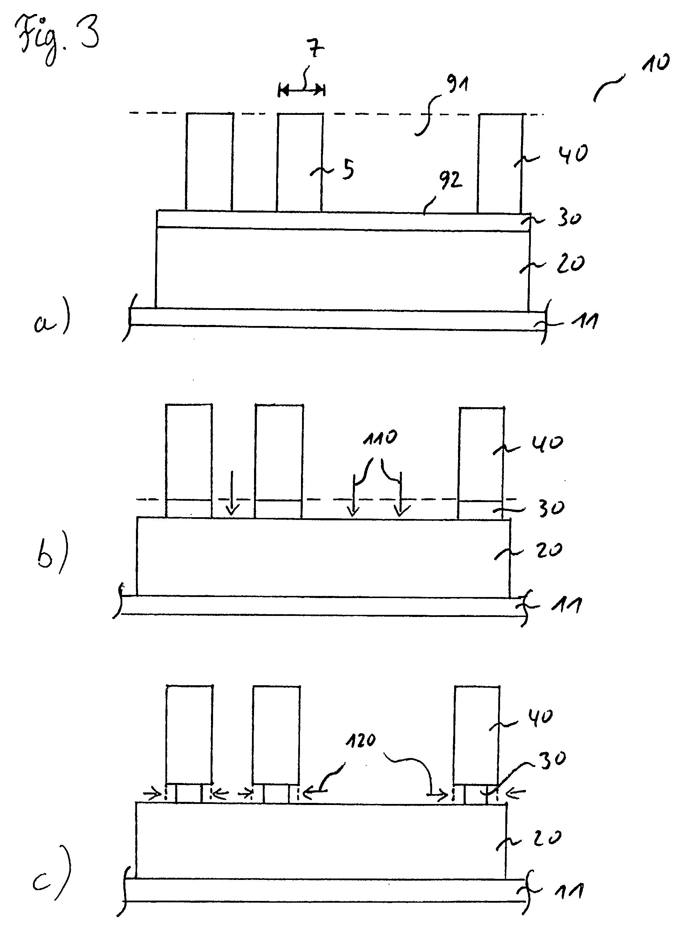

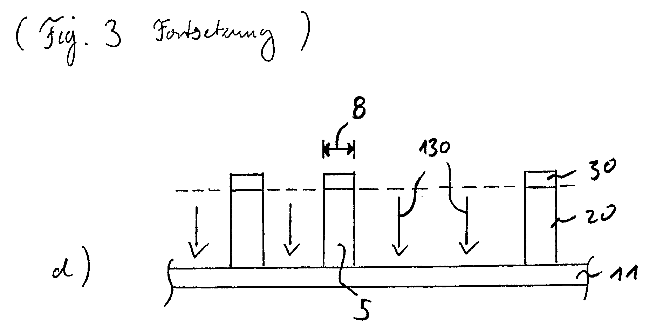

In figure 3, the process sequence of an embodiment of the method according to the present invention is displayed in sideview profiles at four different stages (figures 3a - d). On the substrate 11, a first layer 20 is formed comprising aluminum and a thin top layer of titan nitride (not separatedly shown), and a hardmask layer 30 comprising oxide is deposited on top of the titan nitride layer. A resist layer 40 is coated on top of this material stack. In a lithographic projection step, a pattern including a line structure 5 is formed in the resist layer 40, the line 5 having a line width 7 amounting to 0,13 µm. A portion 91 is removed from the resist layer 40 in a development step. A surface portion 92 of the oxide hardmask layer 30 is thus exposed to the wafer surface.

A first anisotropic etch step is performed on the oxide hardmask layer 30, transferring the resist pattern with line 5 into the hardmask layer 30. The etching can be performed, e.g. with CF₄-oxygen. The first etch step 110 is stopped by end point detection on aluminum (figure 3b). These etch conditions advantageously minimize the loss of resist during the etching.

Next, a second isotropic etching 120 is performed on the patterned oxide hardmask layer 30 beneath the patterned resist layer 40. Again, CF₄-oxygen is used as a reactive compound to provide a high selectivity of the etch process towards the oxide as compared with the organic resist. In this embodiment, the isotropic etching was performed with a CDE 80 (Shibaura), where the plasma is generated externally in a tube, thus inhibiting direct ion bombardment. Advantageously, it is also possible to perform the first and second etch step within the same chamber of an etching tool, e.g. in a LAM TCP or Applied Materials DPS: at detecting the end point of the anisotropic etching step 110, i.e. by means of aluminum surface characteristics, RF-power of the etch tool can be reduced decreasing the directed ion bombardment, a transition to isotropic etching occurs (figure 3c).

Then, the resist layer 40 on top of the reduced line width oxide patterns 30 is removed. The reduced line width 8 of the hardmask pattern now is 0,10 µm. The line width 8 is controlled by a time-controlled etch step 120. The thin oxide hardmask layer 30 beneath the resist layer 40 prior to being removed provides an advantageous configuration for time-controlled etching because the etch direction corresponds to a one-dimensional horizontal movement across the aluminum or titan nitride surface. The resist layer 40 above is marginally affected by the CF₄-oxygen etch process.

To form the line 5 within said first layer 20 comprising aluminum, a third etch step 130 is performed anisotropically with an end point detection on substrate 11. The reduced line width 8 amounting to 0,10 µm is transferred into line 5 within this layer. Thus, with a design rule of 0,13 µm used in the lithographic projection step, a line 5 having sub resolution line width is formed in the first layer 20 (figure 3d).

In a further embodiment, first layer 20 comprises oxide and the hardmask layer 30 corresponds to a poly-silicon mask coated with a resist layer 40. The sequence of steps is similar to the first embodiment, while the same etch gas mixture may be applied to anisotropically and isotropically etch poly-silicon with a high selectivity to the organic resist and the underlying oxide layer 20, which is to receive the line structure 5. Poly-silicon may, e. g., be etched with chlorine with an etch rate of 50-500 nm/min, which can be accurately controlled depending on pressure or RF-power in the plasma chamber. Adding helium to the gas mixture helps to control the etch process. With these parameters, selectivity and etch rate can be controlled to provide the advantageous under-etching of the hardmask layer 30.

It is also possible to start with a first etch step 110 in an isotropical manner, thereby using the end-point detection of aluminum just as an intermediate information signal, and then adding the calculated time necessary to remove the desired portions of the hardmask layer 30 hidden beneath the patterned resist layer 40.

### List of reference numerals

- 5: line, line structure
- 7: line width, due to lithographic projection
- 8: line width, reduced by etching a thin hardmask layer
- 9: line width, reduced by etching organic material stack
- 10: wafer
- 11: substrate
- 20: first layer
- 30: hardmask layer
- 40: resist layer
- 91: portion of resist, removed by development
- 92: exposed surface of hardmask layer
- 110: first etch step
- 120: second etch step
- 130: third etch step

## Claims

1. Method of forming a line (5) structure in a first layer (20) of a semiconductor wafer (10), comprising the steps of:
- depositing said first layer (20) on said wafer (10),
- depositing a hardmask layer (30) comprising anorganic material upon said first layer (20),
- depositing a resist layer (40) upon said hardmask layer (30),
- exposing said resist layer (40) with a pattern comprising said line (5) having a first linewidth (7),
- removing a patterned portion (91) from said resist layer (40), such that an underlying portion (92) of said hardmask layer (30) is exposed to the wafer surface,
- a first etch step (110) being performed on said portion (92) of said hardmask layer (30) using said patterned resist layer (40) as a first etch mask to form a hardmask pattern comprising said line (5) within said hardmask layer (30),
- a second etch step (120) being performed isotropically on said hardmask layer (30) beneath said patterned resist layer (40) for reducing said first linewidth (7) of said line (5) to a second linewidth (8) within said hardmask layer (30),
- removing said resist layer (40),
- a third etch step (130) being performed anisotropically on said hardmask layer (30) for transferring said hardmask pattern into said first layer (20) to form said line (5) within said first layer (20).

2. Method according to claim 1,
**characterized by**
removing said hardmask layer (30) after finishing the third anisotropic etch step.

3. Method according to claims 1 or 2,
**characterized in that**
said first etch step (110) is performed isotropically.

4. Method according to claim 3,
**characterized in that**
said first (110) and second etch steps (120) are performed in an etch process tool without interrupting the isotropic etch process.

5. Method according to claims 1 or 2,
**characterized in that**
said first etch step (110) is performed anisotropically with an etch stop on said first layer (20).

6. Method according to anyone of claims 1 - 5,
**characterized in that**
said hardmask layer (30) comprises an oxide and/or a nitride and said first layer (20) comprises a metal and/or poly-silicon.

7. Method according to anyone of claims 1 - 6,
**characterized in that**
said hardmask layer (30) is an anorganic anti-reflex coating for use in combination with said resist layer (40).

8. Method according to anyone of claims 1 - 7,
**characterized in that**
a fixed time duration with an end-point is set prior to starting the second etch step (120) and said second etch step (120) is stopped, when reaching said end-point.

9. Method according to anyone of claim 8,
**characterized in that**
said fixed time duration is determined by
- measuring the rate of isotropic etch material removal per time unit for the second etch process (120),
- setting a value for said second linewidth (8),
- subtracting said value from said first linewidth (7) of said resist pattern for obtaining a linewidth difference,
- dividing said linewidth difference by said removal rate,
- dividing the result by a factor of 2.
